# FASCICULE DE BREVET EUROPEEN

(11) **EP 3 783 644 B1**
(45) Date de publication et mention de la délivrance du brevet: **28.12.2022**
(21) Numéro de dépôt: 20190405.9
(22) Date de dépôt: 11.08.2020
(51) Int. Cl.: H01L 21/8234, H01L 29/78, H01L 21/28, H01L 29/66

(54) **PROCÉDÉ DE FABRICATION DE COMPOSANTS MICROÉLECTRONIQUES**
VERFAHREN ZUR HERSTELLUNG VON MIKROELEKTRONISCHEN KOMPONENTEN
METHOD FOR MANUFACTURING MICROELECTRONIC COMPONENTS

(30) Priorité: 23.08.2019 FR 1909376
(43) Date de publication de la demande: 24.02.2021
(73) Titulaire: Commissariat à l'Energie Atomique et aux Energies Alternatives, 75015 Paris (FR)
(72) Inventeur: POSSEME, Nicolas, 38054 GRENOBLE (FR); LE ROYER, Cyrille, 38054 GRENOBLE (FR); NEMOUCHI, Fabrice, 38054 GRENOBLE (FR)
(74) Mandataire: Hautier IP

(56) Documents cités:
- US-A1- 2010 084 712
- US-A1- 2012 025 318
- US-A1- 2012 104 500

## Description

### DOMAINE TECHNIQUE

La présente invention concerne le domaine de la fabrication de composants micro-électroniques. Elle trouvera pour application la fabrication de composants à base de transistors, ces composants permettant par exemple de former des circuits CMOS (pour Complementary Metal Oxide Semiconductor) ou des mémoires volatiles telles que les mémoires Flash ou des mémoires non volatiles telles que les mémoires SRAM (Static Random Access Memory).

### ÉTAT DE LA TECHNIQUE

Dans le domaine considéré ci-dessus, on connaît des technologies de fabrication de transistors basés sur des substrats de diverses technologies. Il peut s'agir de substrats de type SOI (acronyme de Silicon On Insulator) comprenant une couche sous-jacente de semi-conducteur (souvent du silicium), surmontée d'une couche d'oxyde dite BOX, puis d'une couche surfacique de semi-conducteur, tel du silicium monocristallin. Un raffinement des substrats SOI est la technologie FDSOI (en anglais Fully Depleted Silicon On Insulator) qui correspond à un support du type couche superficielle d'une plaque de silicium sur isolant totalement déplétée.

Un type simple de substrats est dit « massif », dénommé en anglais «bulk ». Ces substrats comprennent globalement une base en un matériau semi-conducteur, typiquement du silicium, et des zones électriquement isolantes, typiquement en dioxyde de silicium. Les zones électriquement isolantes sont exposées au niveau d'une des faces du substrat et délimitent des zones exposées faites du matériau semiconducteur. Ainsi, les zones électriquement isolantes ont une fonction de séparation électrique entre différentes zones de matériau semi-conducteur, encore dénommées zones actives. Ces zones actives sont le lieu de fabrication de transistors. Il est en particulier connu de fabriquer les zones d'isolation électrique par la réalisation de tranchées latérales d'isolation dites STI, acronyme de l'anglais « shallow trench isolation » c'est-à-dire « tranchées d'isolation peu profondes ».

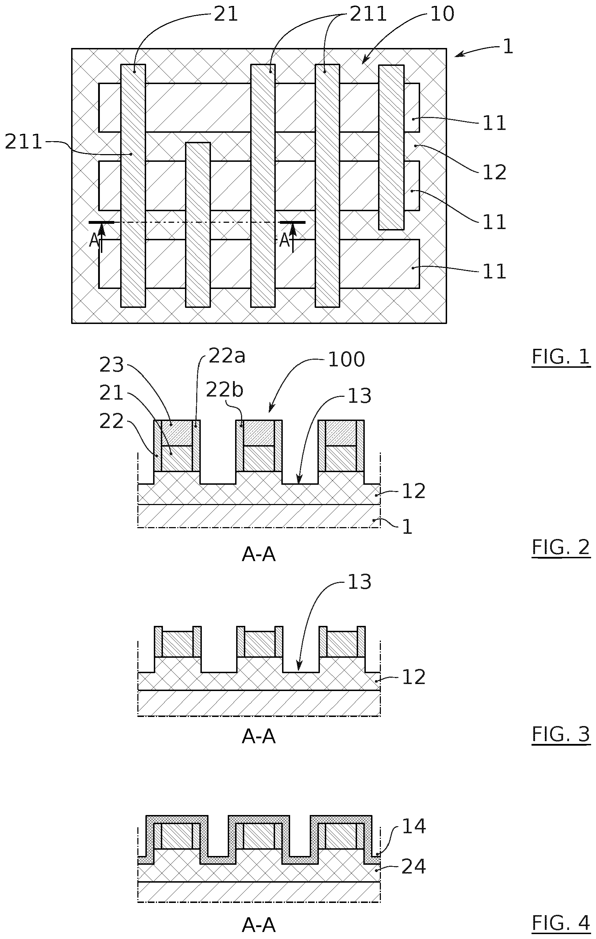

Dans ce contexte, la figure 1 présente en vue de dessus un schéma d'un substrat 1 doté, sur une première face 10, de zones exposées comprenant des zones actives 11 et des zones d'isolation électrique 12. Des grilles de transistors 21 peuvent être formées sur la base de barreaux dirigés transversalement, et plus particulièrement perpendiculairement, à l'orientation longitudinale des zones actives 11.

On sait par ailleurs que la réalisation de composants CMOS peut nécessiter l'ajout de couches permettant d'apporter de la contrainte (en compression ou respectivement en tension) permettant d'accroître les performances des dispositifs, en particulier des transistors à effet de champ (de type P ou respectivement N). Ces couches de contraintes sont aussi appelées «stress liner » ou CESL (Contact Etch Stop Liner). Leur efficacité dépend de l'épaisseur de la couche, souvent réalisée à base de nitrure de silicium. Mais leur dépôt provoque des défauts de remplissage qui se traduisent par la mise en court-circuit de composants micro-électroniques voisins.

Les figures 2 à 7B expliquent ces défauts. Elles représentent des vues en coupe au niveau de la ligne A-A de la figure 1, de sorte à montrer l'impact des étapes de fabrication sur les zones d'isolation électrique. Elles présentent de manière résumée des phases successives de fabrication de composants.

À la figure 2, on a fabriqué, sur la base du substrat 1, des grilles 21 (généralement en polysilicium avec une couche électriquement isolante sous-jacente, typiquement d'oxyde, non représentée sur les figures). Par ailleurs, à ce stade, des espaceurs 22 ont été formés par un dépôt de couche d'espaceurs, par exemple du nitrure de silicium, et une gravure, avec les techniques bien connues de photolithographie et de gravure. Un masque dur 23 surplombe la grille 21 des transistors durant cette étape qui comporte aussi la fabrication de zones de sources/drains sur des portions de la zone active où le transistor est présent, ces portions étant adjacentes à la grille du transistor. Cette fabrication implique des dopages successifs, de type N et de type P pour former les deux natures de transistors des technologies CMOS. Durant ces étapes, la zone d'isolation électrique 12 est affectée de sorte qu'une zone consommée 13 apparaît à sa surface, sous forme de reliefs en creux. Cette zone consommée 13 est dénommée cavité par la suite.

De même, l'étape de retrait du masque dur 23 présentée à la figure 3 aggrave la consommation du matériau de la zone d'isolation électrique 12 au niveau de la cavité 13. Le matériau formant la zone d'isolation électrique 12 est appelé matériau diélectrique dans la suite.

Une étape suivante peut être le dépôt d'un revêtement de protection des grilles, sous forme d'une couche 14, par exemple de nitrure de silicium, tel qu'illustré en figure 4.

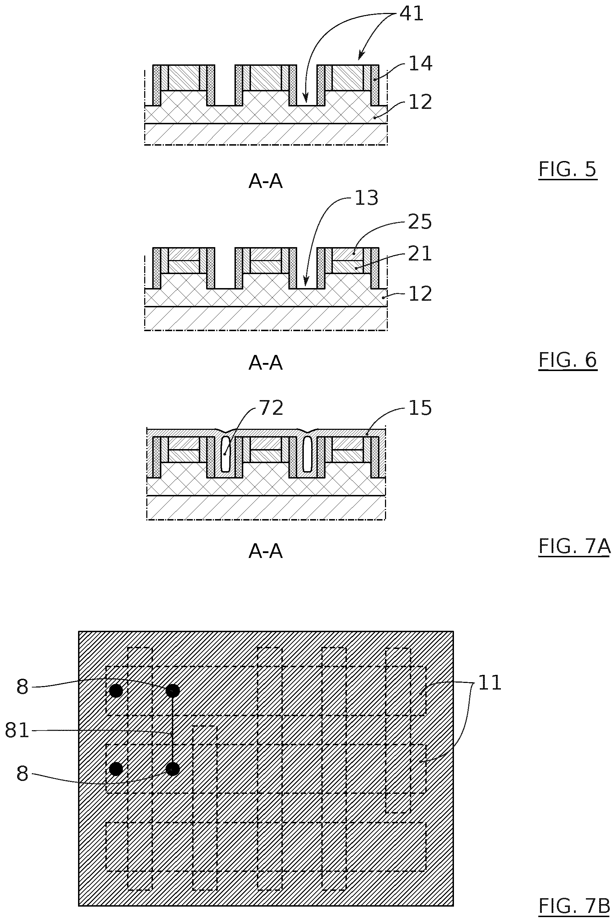

Comme le montre la figure 5, cette protection doit ensuite être retirée sélectivement sur les parties horizontales pour dégager le haut de la grille et la surface horizontale des zones d'isolation 12. Pour cela des ouvertures 41 sont formées dans la couche de protection 14. Cette étape induit une consommation supplémentaire du matériau diélectrique formant les zones d'isolation 12.

Des étapes suivantes sont présentées à la figure 6 avec une siliciuration d'une portion 25 du haut de la grille 21 et simultanément des sources et drains des zones actives (non représentés sur la coupe).

À noter que ces étapes incluent généralement un ou plusieurs traitements thermiques ainsi que des phases de nettoyage (par voie humide et/ou plasma) également dommageables à l'intégrité du matériau diélectrique.

Finalement, une couche mécaniquement contraignante 15 peut être déposée. Compte tenu de la consommation indésirable du matériau diélectrique entre deux transistors adjacents, le rapport de forme des cavités 13 est augmenté ce qui pénalise la fiabilité du remplissage des espaces entre deux grilles de transistors adjacents. La figure 7A révèle que des vides 72 peuvent subsister au sein même de la couche mécaniquement contraignante 15. Ces vides résiduels ne peuvent malheureusement pas être remplis par d'autres couches au-dessus de la couche mécaniquement contraignante 15, telle qu'une couche supérieure d'isolant électrique généralement en dioxyde de silicium. Ce défaut de remplissage est d'autant plus critique que l'étage de transistors ainsi constitué est noyé en milieu de ligne (de l'anglais «middle of line ») d'un dispositif micro-électronique complet.

Les vides résiduels ainsi formés s'étendent typiquement le long des barreaux transversaux 211 de grilles, d'une zone active 11 à l'autre (cf. figure 1). Cela peut avoir des conséquences néfastes lorsqu'un de ces vides est ouvert lors d'une formation ultérieure des contacts électriques, en particulier lorsqu'un problème d'alignement de ces contacts survient. Dans ce cas, lors du dépôt du matériau conducteur (par exemple du tungstène), notamment par dépôt chimique en phase vapeur, le vide ainsi ouvert se trouve comblé par le matériau conducteur et crée un court-circuit entre deux zones de contact de deux zones actives adjacentes qui ne sont pas censées être connectées électriquement. La figure 7B révèle de manière schématique deux éléments de contact 8 présents sur des zones actives 11 adjacentes et reliés par une zone de court-circuit 81 formée de manière indésirable au travers d'un vide résiduel lié à un défaut de remplissage de la couche mécaniquement contraignante 15.

Au regard de ces inconvénients, il est actuellement nécessaire de préserver un espace important entre deux transistors adjacents ce qui implique soit une limitation de densité d'implantation des transistors sur le substrat, soit une étape supplémentaire de gravure de la couche de protection 14 pour accroître la largeur des espaces entre les transistors. Une telle étape supplémentaire peut en outre affecter les autres constituants du transistor, en particulier la portion siliciurée, le matériau semiconducteur des zones actives ou encore le matériau diélectrique lui-même.

Les documents US2012/025318A1 et US2012/104500A1 décrivent différents procédés visant à éviter ou réparer les vides résiduels. Ces procédés ne sont pas totalement satisfaisants. Le document US2010/084712A1 présente une méthode pour former des espaceurs de dispositifs semi-conducteurs.

Il existe par conséquent un besoin d'améliorer les techniques de fabrication de composants micro-électroniques actuelles.

La présente invention a notamment pour objet un procédé de réalisation de composant à base de transistors supprimant ou limitant l'apparition de vides résiduels dans les zones d'isolation électriques.

### RÉSUMÉ

Un aspect de l'invention concerne un procédé de réalisation d'un composant à base d'une pluralité de transistors sur un substrat comprenant au moins une zone active et une zone d'isolation électrique, chaque transistor de la pluralité de transistors comprenant une grille et des espaceurs de part et d'autre de la grille, l'au moins une zone d'isolation électrique comprenant au moins une cavité formée en creux entre un espaceur d'un premier transistor de la pluralité de transistors et un espaceur d'un deuxième transistor de la pluralité de transistors, lesdits premier et deuxième transistors étant adjacents. Ce procédé comprend :
- une formation des grilles des transistors,
- une formation des espaceurs, et
- une formation d'une couche mécaniquement contraignante pour les transistors.

Le procédé comprend en outre, après la formation des espaceurs et avant la formation de la couche mécaniquement contraignante :
- un remplissage configuré pour remplir au moins partiellement par un matériau de remplissage l'au moins une cavité au sein de l'au moins une zone d'isolation électrique, entre l'espaceur du premier transistor et l'espaceur du deuxième transistor.

Le procédé comprend en outre :
- au moins une étape technologique ultérieure au remplissage et impliquant une consommation du matériau, dit matériau diélectrique, de l'au moins une zone d'isolation électrique au niveau de portions exposées de l'au moins une zone d'isolation électrique.

Le matériau de remplissage est à base d'un matériau carboné configuré pour ne pas être consommé lors de l'au moins une étape technologique impliquant une consommation du matériau diélectrique. Le matériau de remplissage est retiré avant un traitement thermique haute température pris parmi un recuit de diffusion et un recuit d'activation.

La présente invention fournit ainsi une solution permettant de stopper un approfondissement des cavités présentes dans les zones d'isolation électrique (tranchées d'isolation) après formation des espaceurs des transistors. Cette solution permet éventuellement d'éliminer ces cavités en les remplissant par le matériau de remplissage. Bien qu'il soit avantageux que les cavités soient intégralement supprimées, par un remplissage complet de leur volume, il est possible de n'opérer qu'un remplissage partiel qui, pour le moins, limite les inconvénients des cavités. Eventuellement, ce remplissage partiel peut tapisser la paroi de la cavité pour former une couche plus résistante aux étapes de traitement à suivre (dont des gravures) que la couche dans laquelle les cavités sont présentes.

Lors des étapes ultérieures (retrait des masques d'implantation, retrait du masque dur, gravure anisotrope, phases de nettoyage notamment) et avant de couvrir l'ensemble des grilles par la couche mécaniquement contraignante (stress liner), les cavités sont protégées par le matériau de remplissage.

La consommation progressive du matériau des tranchées d'isolation lors de ces différentes étapes ultérieures est ainsi empêchée. La taille des cavités reste limitée. Cela permet d'éviter la formation de vides résiduels après dépôt du stress liner.

Le remplissage par le stress liner des espaces entres les grilles est amélioré. Les vides résiduels sont évités.

### BRÈVE DESCRIPTION DES FIGURES

Des buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 illustre schématiquement, en vue de dessus, un substrat comprenant des zones actives et des zones d'isolation électrique adjacentes, sur lesquelles sont disposées des grilles de transistors.
La figure 2 illustre schématiquement en coupe transverse une étape de formation des espaceurs de grille, selon l'État la technique.
La figure 3 illustre schématiquement en coupe transverse une étape de retrait de masque dur, ultérieure à celle de la figure 2, selon l'État la technique.
La figure 4 illustre schématiquement en coupe transverse une étape de dépôt d'une couche de protection, ultérieure à celle de la figure 3, selon l'État la technique.
La figure 5 illustre schématiquement en coupe transverse une étape de gravure anisotrope, ultérieure à celle de la figure 4, selon l'État la technique.
La figure 6 illustre schématiquement en coupe transverse une étape de siliciuration, ultérieure à celle de la figure 5, selon l'état de la technique.
La figure 7A illustre schématiquement en coupe transverse une étape de formation d'une couche mécaniquement contraignante, ultérieure à celle de la figure 6, selon l'État la technique.
La figure 7B présente une vue de dessus schématisant un court-circuit entre deux contacts électriques.
La figure 8 illustre schématiquement en coupe transverse une situation d'endommagement de zones d'isolation électrique après formation des espaceurs de grille des transistors, selon l'État la technique.
La figure 9 illustre schématiquement en coupe transverse, une étape de dépôt d'un matériau de remplissage à partir de la situation illustrée à la figure 8, selon un premier mode de réalisation de l'invention.
La figure 10 illustre schématiquement en coupe transverse, une étape de gravure du matériau de remplissage, ultérieure à celle de la figure 9, selon un premier mode de réalisation de l'invention.
La figure 11 illustre schématiquement en coupe transverse, une étape de retrait de masque dur, ultérieure à celle de la figure 10, selon un premier mode de réalisation de l'invention.
La figure 12 illustre schématiquement en coupe transverse, une étape de gravure anisotrope d'une couche de protection, ultérieure à celle de la figure 11, selon un premier mode de réalisation de l'invention.
La figure 13 illustre schématiquement en coupe transverse, une étape de retrait du matériau de remplissage, ultérieure à celle de la figure 12, selon un premier mode de réalisation de l'invention.
La figure 14 illustre schématiquement en coupe transverse une situation d'endommagement de zones d'isolation électrique après formation des espaceurs de grille des transistors, selon l'État la technique.
La figure 15 illustre schématiquement en coupe transverse, une étape de dépôt d'un matériau de remplissage à partir de la situation illustrée à la figure 14, selon un deuxième mode de réalisation non revendiqué.
La figure 16 illustre schématiquement en coupe transverse, une étape de gravure du matériau de remplissage, ultérieure à celle de la figure 15, selon un deuxième mode de réalisation non revendiqué.
La figure 17 illustre schématiquement en coupe transverse, une étape de gravure anisotrope d'une couche de protection, ultérieure à celle de la figure 16, selon un deuxième mode de réalisation non revendiqué.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches ne sont pas représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement.

Suivant une possibilité, le remplissage n'est que partiel, en ce sens qu'une partie du volume défini par la cavité n'est pas comblée par un bouchon. Dans un autre cas, le remplissage est complet ; il ne subsiste alors plus de volume résiduel de cavité. Le bouchon de matériau de remplissage peut alors être le complémentaire de la cavité dans la zone d'isolation en affleurant au niveau de la surface exposée de ladite couche. Le matériau de remplissage peut aussi, éventuellement, être tel que son volume soit saillant au-delà de la surface de la zone d'isolation, formant ainsi un relief. Dans ce cas, le volume du bouchon de matériau de remplissage est supérieur à celui de la cavité.

Selon un exemple, le procédé comprend en outre une formation de zones de source et de drain par dopage de portions de l'au moins une zone active, lesdites portions étant situées de part et d'autre des grilles.

Selon un exemple, le remplissage de l'au moins une cavité est effectué après ladite formation de zones de source et de drain.

Selon un exemple, le remplissage comprend un dépôt du matériau de remplissage entre les premier et deuxième espaceurs, dans et hors de l'au moins une cavité, suivi d'une gravure du matériau de remplissage configurée pour retirer une partie dite sacrificielle du matériau de remplissage hors des cavités en conservant une partie dite utile du matériau de remplissage dans les cavités, la partie utile formant un bouchon. Cela correspond au cas discuté précédemment dans lequel, au final, le matériau de remplissage n'occupe que la cavité ou seulement une partie de la cavité.

Selon un exemple, la gravure est une gravure sélective dudit matériau de remplissage vis-à-vis du matériau d'espaceurs et du matériau de l'au moins une zone active.

Le procédé comprend en outre au moins une étape technologique ultérieure au remplissage et impliquant une consommation du matériau, dit matériau diélectrique, de l'au moins une zone d'isolation électrique au niveau de portions exposées de l'au moins une zone d'isolation électrique.

Le matériau de remplissage est à base d'un matériau configuré pour ne pas être consommé lors de l'au moins une étape technologique impliquant une consommation du matériau diélectrique.

Le matériau de remplissage est à base d'un matériau carboné. Selon un exemple, le remplissage forme une pluralité de bouchons, chaque bouchon remplissant une cavité au sein de l'au moins une zone d'isolation électrique et présentant une hauteur sensiblement égale à une profondeur de ladite cavité de façon à combler ladite cavité.

Les bouchons à base du matériau carboné sont retirés avant un traitement thermique haute température pris parmi un recuit de diffusion et un recuit d'activation.

Selon un exemple non couvert par la présente invention, le matériau de remplissage est au moins partiellement consommé lors de l'au moins une étape technologique impliquant une consommation du matériau diélectrique.

Selon un exemple non couvert par la présente invention, le remplissage est répété plusieurs fois avant la formation de la couche mécaniquement contraignante, de façon à pallier ladite consommation du matériau de remplissage.

Selon un exemple non couvert par la présente invention, le matériau de remplissage est à base d'un oxyde de silicium.

Selon un exemple non couvert par la présente invention, le remplissage forme une pluralité de bouchons, chaque bouchon remplissant une cavité au sein de l'au moins une zone d'isolation électrique et présentant une hauteur strictement supérieure à une profondeur de ladite cavité, de sorte qu'une partie inférieure du bouchon soit située dans la cavité et qu'une partie supérieure du bouchon soit située hors de la cavité.

Selon un exemple non couvert par la présente invention, la partie supérieure du bouchon présente une épaisseur, dite surépaisseur, supérieure ou égale à 5 nm et/ou inférieure ou égale à 20 nm.

**Il** est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact soit en étant séparée d'elle par au moins une autre couche ou au moins un autre élément.

Une couche peut, par ailleurs, être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les STI et les espaceurs sont typiquement formés en un matériau diélectrique.

Les termes « motif de grille », «empilement de grille », « grille » sont employés en synonymes.

Dans la présente demande de brevet, une cavité correspond à un vide formé au sein de la zone d'isolation électrique, ce vide étant ouvert en surface de ladite zone d'isolation électrique, ce vide s'étendant en outre entre deux espaceurs de deux transistors respectifs adjacents, au droit desdits espaceurs. Le creux formé par la cavité 13 s'entend par rapport à un plan confondu avec l'interface zone d'isolation/grille.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principal de la couche, la hauteur et la profondeur sont prises selon une direction normale au plan de base du substrat.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

Pour déterminer la géométrie des transistors et la disposition des différentes couches, on peut procéder à des analyses de microscopie électronique, en particulier de Microscopie Electronique à Balayage (MEB) ou de Microscopie Electronique en Transmission (MET ou TEM).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de portions de faibles dimensions telles que les cavités remplies par le matériau de remplissage. Elle peut être mise en œuvre sur des coupes métallurgiques au sein d'un MEB ou d'un MET.

Ces techniques permettent notamment de déterminer s'il y a des vides résiduels dans les tranchées d'isolation et le cas échéant leurs dimensions, et/ou s'il y a eu réparation de cavités dans les tranchées d'isolation par remplissage avant formation du stress liner.

L'absence de vides résiduels et/ou des cavités remplies par un matériau de remplissage sont caractéristiques de la mise en œuvre du procédé selon l'invention. Ils peuvent donc être un indice de la mise en œuvre du procédé selon l'invention.

Le procédé de fabrication de transistors va maintenant être décrit en détail au travers de deux modes de réalisation.

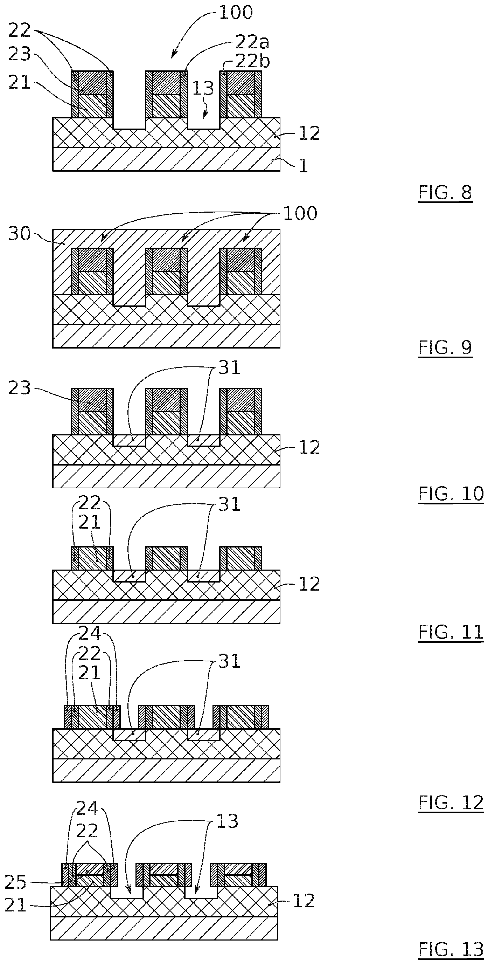

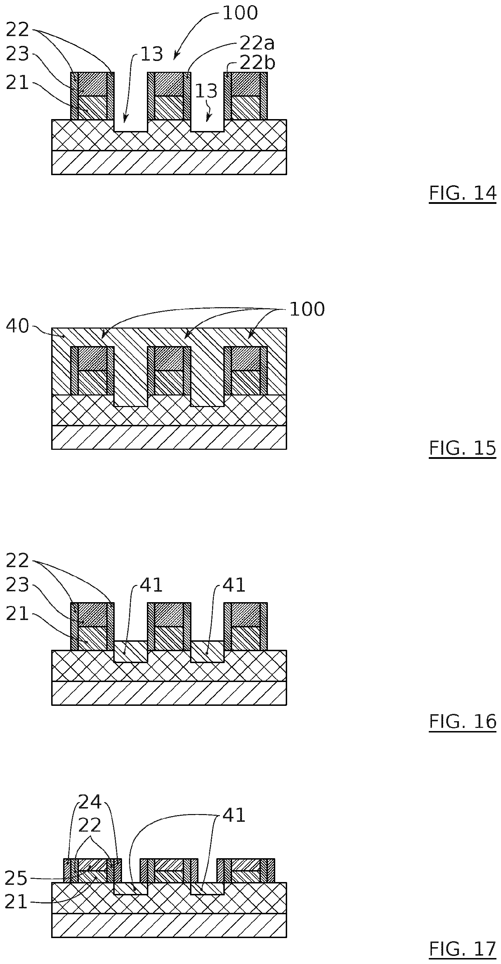

Pour ces deux modes de réalisation, le procédé comprend une partie d'étapes de fabrication classiques de transistors visant à former sur un substrat, pour chacun des transistors, un motif de grille 100 flanqué d'espaceurs 22, tel qu'illustré aux figures 8 et 14.

Le substrat 1 peut comprendre une partie dite massive ou « bulk » selon la terminologie anglo-saxonne, des zones actives 11 en matériau semiconducteur, et des zones d'isolation 12 en matériau diélectrique.

Le substrat peut également être de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator).

Dans tous les cas, les transistors sont formés sur les zones actives 11 et isolés électriquement par les zones d'isolation 12, typiquement des tranchées d'isolation de type STI (shallow trench isolation) à base d'oxyde de silicium.

Le motif de grille 100 comprend typiquement une grille 21 et un masque dur 23 en nitrure de silicium (SiN). Le motif de grille 100 peut présenter une largeur dite dimension critique comprise entre 10 nm et 100 nm et de préférence inférieure ou égale à 50 nm.

Il peut présenter une hauteur de l'ordre de quelques dizaines de nanomètres. La grille 21 présente typiquement une hauteur inférieure ou égale à 100 nm, par exemple environ égale à 50 nm. La hauteur du masque dur 23 est généralement comprise entre 40 et 80 nanomètres.

Deux motifs de grille voisins sont séparés par un pas typiquement inférieur ou égal à 120 nm.

Deux motifs de grille voisins peuvent s'étendre selon des directions transverses aux directions d'extension principales des zones actives 11 et STI 12 (figure 1). En particulier, un même motif de grille peut surmonter alternativement une ou plusieurs zones actives 11 et une ou plusieurs tranchées STI 12 adjacentes.

Des espaceurs 22 sont formés le long des flancs de ce motif de grille 1. Les flancs des motifs de grille s'étendent selon des plans sensiblement normaux au plan de base du substrat.

En général, mais non limitativement, un espaceur forme une bague autour de la grille, avec un contour fermé ; on pourrait donc parler d'un espaceur unique autour de la grille; cependant, les représentations en coupe, et les directions privilégiées des grilles, font que l'on parle aussi de paires d'espaceurs (ou premier et deuxième espaceurs), terminologie ici retenue.

De façon connue, la formation de ces espaceurs 22 peut comprendre un dépôt conforme d'une couche notamment de SiN sur et entre les motifs de grille 1, suivie d'une gravure anisotrope du SiN,.

Le dépôt peut typiquement se faire par CVD, acronyme de l'anglais «chemical vapor déposition», ou ALD, acronyme de l'anglais « Atomic Layer déposition», de façon à former une couche de SiN présentant une épaisseur inférieure ou égale à 15 nm, par exemple comprise entre 6 nm et 15 nm, de préférence entre 8 nm et 12 nm.

Alternativement au SiN, un matériau diélectrique de type Low-k (de constante diélectrique k<7) peut être utilisé pour former les espaceurs 22. Par exemple et non limitativement, ce matériau peut être du SiBCN ou du SiCO. La « couche en SiN » à laquelle il est fait référence par souci de clarté peut donc s'entendre de « la couche en un matériau diélectrique de type low-k utilisé pour former les espaceurs 22 ». Aussi, les espaceurs peuvent être en oxyde ou en un bicouche Oxyde-nitrure. Des matériaux Low-k ont l'avantage de limiter les problèmes de capacités parasites.

La gravure anisotrope est configurée pour consommer les portions de couche en SiN situées au sommet des motifs de grille et entre les motifs de grille, sur le substrat. Elle peut être réalisée par plasma, par exemple à base d'une chimie de type fluorocarbonée, dans un réacteur plasma à couplage inductif ICP (Inductively Coupled Plasma).

Le facteur de forme des motifs de grille 100 induit généralement une consommation plus rapide des portions de couche à la base des motifs de grille, sur le substrat, par rapport aux portions de couche au sommet des motifs de grille.

Cela induit un phénomène de surgravure au niveau des zones exposées du substrat, notamment au niveau des zones exposées des STI 12.

Dès lors, des cavités 13 se forment en surface des tranchées STI 12 exposées. Les cavités 13 sont bordées latéralement par un premier espaceur 22a d'un premier transistor et par un deuxième espaceur 22b d'un deuxième transistor comme référencé en figure 8 (et en figure 14).

Lors des étapes de fabrication classiques suivantes (notamment dopage par implantation des zones actives pour la fabrication des source et drain, et épitaxies éventuelles au niveau des zones actives par exemple pour la fabrication de source et drain surélevés dits RSD ou « Raised Source Drain »), ces cavités 13 peuvent se développer et leur profondeur peut augmenter.

Le procédé selon l'invention vise à limiter ou supprimer les inconvénients liés à la présence de ces cavités 13.

Selon un premier mode de réalisation illustré aux figures 8 à 13, le procédé comprend, après formation des premiers espaceurs 22 et après un premier dopage par implantation, une étape de remplissage des cavités par dépôt d'un matériau carboné.

Tel qu'illustré à la figure 9, un dépôt d'une couche carbonée 30 peut être effectué par exemple par centrifugation, de manière à remplir les espaces entre les motifs de grille 100. Cette couche carbonée 30 peut éventuellement couvrir le sommet des motifs de grille 100. Cette couche 30 peut ainsi servir à encapsuler tous les éléments sous-jacents.

Cette couche carbonée 30, par exemple de carbone amorphe, peut être, de manière non limitative, formé à partir d'une résine carbonée dont les propriétés de viscosité sont adaptées à un étalement par centrifugation. Un recuit après étalement peut permettre d'évaporer les solvants et/ou de réticuler la résine de façon à obtenir la couche carbonée 30 solide.

Différentes résines carbonées pourront être utilisées, telles que : polymethyl methacrylate (PMMA) ou polydimethylsiloxane (PDMS).

L'épaisseur de la couche carbonée 30 obtenue dépend notamment du facteur de forme des motifs de grille, de la viscosité de la résine, des paramètres d'étalement (vitesse de centrifugation, durée d'étalement) et du recuit (température, durée de recuit).

Tel qu'illustré à la figure 10, une gravure partielle de la couche carbonée 30 est effectuée de manière à ne conserver qu'un bouchon 31 de matériau carboné dans chaque cavité 13 des STI 12.

La gravure est de préférence effectuée par plasma dans un réacteur plasma à couplage inductif ICP (Inductively Coupled Plasma) ou à couplage capacitif CCP (Capactively Coupled Plasma). Ce plasma peut être à base d'oxygène.

La gravure partielle est de préférence configurée pour obtenir un bouchon 31 présentant sensiblement la même épaisseur que la profondeur de la cavité 13 qu'il remplit. La surface entre les espaceurs 22a, 22b des transistors adjacents peut ainsi être aussi plane que possible.

Un tel bouchon 31 en matériau carboné n'est avantageusement pas consommé lors des étapes suivantes de fabrication des transistors, en particulier du fait des chimies utilisées lors des étapes de retrait du masque dur 23 et de nettoyage pré-siliciuration, notamment à base de HF et de plasma direct ou déporté attaquant l'oxyde natif présent sur les sources et drain et la grille.

Tel qu'illustré à la figure 11, le masque dur 23 est en effet retiré par gravure anisotrope du SiN. Ce retrait peut aussi induire un enlèvement partiel du matériau des espaceurs 22, retrait non visible sur la figure 11. Ce retrait peut être opéré avec une solution d'acide phosphorique (H₃PO₄), chaud de préférence, en particulier au-delà de 43°C. La sélectivité de cette gravure vis-à-vis de l'oxyde de silicium des STI 12 n'est pas suffisamment élevée pour éviter une consommation de l'oxyde de silicium. Ainsi, en l'absence de bouchon 31, la cavité 13 serait agrandie.

La sélectivité de cette gravure vis-à-vis du matériau carboné du bouchon 31 est suffisamment élevée pour éviter une consommation du matériau carboné. Ainsi, le bouchon 31 est préservé et permet une protection efficace contre l'agrandissement de la cavité 13.

Tel qu'illustré à la figure 12, une couche de protection de préférence en SiN est déposée puis gravée de façon anisotrope. Des portions latérales 24 de la couche de protection sont ainsi conservées sur les flancs des premiers espaceurs 22. Ces portions latérales 24 définissent des deuxièmes espaceurs permettant d'accroître la largeur de matériau recouvrant les flancs des grilles 21 et, par conséquent, de réduire l'espace interstitiel entre deux motifs de grille adjacents. Ces deuxièmes espaceurs permettent de délimiter latéralement une deuxième implantation ionique.

Cette gravure anisotrope de la couche de protection peut être une gravure sèche opérée par plasma.

Le bouchon 31 offre donc une protection efficace contre l'agrandissement de la cavité 13 également lors de cette étape (figure 12).

Les étapes suivantes peuvent comprendre des recuits haute température.

En particulier, un recuit de diffusion et/ou d'activation des dopants implantés lors de la deuxième implantation ionique, souvent appelé « spike anneal », peut être effectué.

Tel qu'illustré à la figure 13, une étape de siliciuration d'une portion 25 de la grille 21 peut également être effectuée.

Cette étape comprend le dépôt d'un métal, par exemple du nickel ou un alliage à base de nickel (Ni), sur le sommet des grilles 21, et plusieurs recuits thermiques visant notamment à faire diffuser le métal dans la grille (recuit de diffusion) pour former un siliciure (NiSi ou NiPtSi) et à passiver ou éviter des défauts électriquement actifs (recuit de siliciuration de type DSA, acronyme de « Dynamic Surface Anneal »).

Le bouchon 31 est retiré, de préférence avant les recuits thermiques, notamment les recuits thermiques rapides à haute température tels que les recuits d'activation « spike anneal » et DSA.

Ce retrait peut se faire par plasma à base d'oxygène. La gravure des bouchons 31 est de préférence la même que la gravure initiale permettant de former les bouchons 31.

Selon une possibilité, le bouchon 31 peut être réalisé plus tard dans l'enchaînement d'étapes de fabrication des transistors, par exemple après retrait du masque dur 23.

Ce bouchon 31 de matériau carboné permet de limiter voire de supprimer la consommation de l'oxyde de silicium au niveau des cavités 13 des STI 12. Les cavités 13 sont ainsi moins profondes. Le facteur de forme des motifs de grille est amélioré.

Le dépôt du stress liner peut ensuite être effectué (non illustré) en limitant l'apparition de vides résiduels.

Typiquement, le stress liner est une couche de nitrure, en particulier une couche de nitrure de silicium (SiN ou SixNy x et y étant des entiers).

Il peut être déposé de façon conforme par l'une des techniques suivantes : dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt thermique CVD rapide (RTCVD, acronyme de rapid thermal CVD), dépôt par couche atomique (ALD, acronyme de atomic layer déposition). D'autres types de dépôts peuvent être envisagés.

Le stress liner peut présenter une épaisseur de quelques nanomètres à quelques dizaines de nanomètres, et notamment une épaisseur comprise entre 5 et 40 nanomètres, par exemple 20 nm.

Il n'est pas exclu de déposer une pluralité de stress liner ou de limiter le dépôt du stress liner à une zone de la face du substrat, et, éventuellement, de revêtir au moins une autre zone de la face du substrat par au moins un autre stress liner, par exemple pour mettre en œuvre des contraintes mécaniques de signes opposés (en compression et en tension).

Selon un deuxième mode de réalisation non revendiqué et illustré aux figures 14 à 17, le procédé comprend, après formation des espaceurs et dopage par implantation (figure 14), une étape de remplissage des cavités par dépôt d'un oxyde de silicium. Plus généralement, il peut s'agir d'un matériau identique à celui sous-jacent (celui dans lequel est formé la STI). Il s'agit d'un matériau susceptible d'être consommé durant au moins une des étapes de traitements indiquées, notamment les gravures, cette consommation étant avantageusement équivalente à celle du matériau des STI.

Tel qu'illustré à la figure 15, un dépôt d'une couche d'oxyde de silicium 40 est effectué de manière à remplir les espaces entre motifs de grille 1. Eventuellement, la couche 40 peut recouvrir les motifs de grille de sorte qu'elle forme une encapsulation de tous les éléments sous-jacents.

Ce dépôt peut se faire par l'une des techniques suivantes : dépôt chimique en phase vapeur FCVD (acronyme de Furnace Chemical Vapor Déposition), dépôt d'oxyde dans des conditions de type HARP (acronyme de High Aspect Ratio Process), Flowable oxide CVD ou dépôt par centrifugation.

Le dépôt d'oxyde appelé HARP utilise des conditions de dépôt optimisées pour remplir les espaces entre motifs 1 étroits et profonds.

Ce dépôt se fait typiquement à partir d'un précurseur TEOS sous atmosphère ozone (O3). Les conditions du dépôt HARP sont de préférence les suivantes :
Le dépôt par centrifugation peut se faire à partir de résines silicatées de type « spin on glass ». Après étalement de la résine silicatée par centrifugation, un recuit permet typiquement de former la couche d'oxyde de silicium 40.

La couche d'oxyde de silicium 40 ainsi formée peut éventuellement couvrir le sommet des motifs de grille 1. L'épaisseur de la couche 40 peut par exemple être supérieure à 15 nm.

Tel qu'illustré à la figure 16, une gravure partielle de la couche d'oxyde de silicium 40 est effectuée de manière à ne conserver qu'un bouchon 41 d'oxyde de silicium dans chaque cavité 13 des STI 12.

La gravure peut être effectuée par voie sèche via un plasma à distance (remote plasma) ou par voie humide via une solution à base d'acide fluorhydrique (HF). Une telle gravure est avantageusement sélective vis-à-vis des matériaux environnants et en particulier vis-à-vis du matériau d'espaceurs 22 (SiN, SiCO, SiCBN par exemple) et du matériau semi-conducteur des zones actives (Si, Ge, SiGe par exemple).

La gravure partielle est de préférence configurée pour obtenir un bouchon 41 présentant une épaisseur strictement supérieure à la profondeur de la cavité 13 qu'il remplit. Ce bouchon 41 présente dès lors une surépaisseur correspondant à une partie hors de la cavité 13, entre les motifs 1.

La surépaisseur de ce bouchon 41 d'oxyde de silicium est de préférence choisie de façon à compenser les consommations de l'oxyde de silicium lors des étapes de gravure et nettoyage ultérieures, en particulier lors des étapes de retrait du masque dur 23 et de nettoyage pré-siliciuration.

Cette surépaisseur peut être notamment supérieure ou égale à 10 nm, par exemple de l'ordre de 15 nm.

Une partie de la surépaisseur du bouchon 41 d'oxyde de silicium est donc consommée lors du retrait du masque dur 23 par gravure anisotrope du SiN. La consommation liée à cette étape de retrait est typiquement de l'ordre de 5 nm.

Une partie de la surépaisseur du bouchon 41 d'oxyde de silicium est également consommée lors de la gravure anisotrope de la couche de protection en SiN (non illustré). La consommation liée à cette étape de gravure est typiquement de l'ordre de 5 nm.

Tel qu'illustré à la figure 17, une partie de la surépaisseur du bouchon 41 d'oxyde de silicium est également consommée lors de étape de siliciuration des portions 25 de grilles 21. La consommation liée à cette étape de siliciuration est typiquement de l'ordre de 5 nm.

Les bouchons 41 d'oxyde de silicium permettent donc de préserver et combler les STI 12 en comblant les cavités 13.

Avantageusement, les bouchons 41 peuvent être conservés lors des recuits thermiques, notamment lors des recuits thermiques rapides à haute température.

Selon une possibilité, l'étape de remplissage des cavités par l'oxyde de silicium peut être répétée au moins une fois après l'une des étapes de gravure et/ou nettoyage. Elle peut éventuellement être répétée après chaque étape de gravure et/ou de nettoyage.

Le bouchon 41 est ainsi régénéré et les STI 12 sont protégés et réparés tout au long des étapes de fabrication des transistors, avant dépôt du stress liner.

Le dépôt du stress liner peut ensuite être effectué (non illustré) en limitant voire en évitant l'apparition de vides résiduels.

Un intérêt de l'invention est d'accroître la fiabilité de fabrication des transistors.

Les étapes ultérieures de formation des contacts électriques sur les zones électriquement actives des transistors (zones source/drain et grille) peuvent notamment se faire sans risque de court-circuit entre deux zones actives 11 lié à un remplissage intempestif d'un vide résiduel au niveau des STI 12.

## Revendications

1. Procédé de réalisation d'un composant à base d'une pluralité de transistors sur un substrat comprenant une zone active (11) et une zone d'isolation électrique (12), chaque transistor de la pluralité de transistors comprenant une grille (21) et des espaceurs (22) de part et d'autre de la grille (21), la zone d'isolation électrique (12) comprenant au moins une cavité (13) formée en creux entre un espaceur (22a) d'un premier transistor de la pluralité de transistors et un espaceur (22b) d'un deuxième transistor de la pluralité de transistors, lesdits premier transistor et deuxième transistor étant adjacents, le procédé comprenant :
- une formation des grilles des transistors,
- une formation des espaceurs, et
- une formation d'une couche mécaniquement contraignante (15) pour les transistors,
- après la formation des espaceurs et avant la formation de la couche mécaniquement contraignante, un remplissage configuré pour remplir au moins partiellement par un matériau de remplissage l'au moins une cavité (13) au sein de la zone d'isolation électrique, entre l'espaceur (22a) du premier transistor et l'espaceur (22b) du deuxième transistor,
le procédé comprenant en outre :
- au moins une étape technologique ultérieure au remplissage et impliquant une consommation du matériau, dit matériau diélectrique, de l'au moins une zone d'isolation électrique au niveau de portions exposées de l'au moins une zone d'isolation électrique,
ledit matériau de remplissage étant à base d'un matériau carboné configuré pour ne pas être consommé lors de l'au moins une étape technologique impliquant une consommation du matériau diélectrique, limitant ou supprimant ainsi la consommation du matériau diélectrique,
le procédé étant **caractérisé en ce que** ledit matériau de remplissage est retiré avant un traitement thermique haute température pris parmi un recuit de diffusion et un recuit d'activation.

2. Procédé selon la revendication précédente comprenant en outre une formation de zones de source et de drain par dopage de portions de la zone active, lesdites portions étant situées de part et d'autre des grilles, dans lequel le remplissage de l'au moins une cavité (13) est effectué après ladite formation de zones de source et de drain.

3. Procédé selon l'une quelconque des revendications précédentes, dans lequel le remplissage est configuré pour remplir complètement par le matériau de remplissage l'au moins une cavité (13).

4. Procédé selon l'une quelconque des revendications précédentes, dans lequel le remplissage comprend un dépôt du matériau de remplissage entre l'espaceur (22a) du premier transistor et l'espaceur (22b) du deuxième transistor, dans et hors de l'au moins une cavité (13), suivi d'une gravure du matériau de remplissage configurée pour retirer une partie dite sacrificielle du matériau de remplissage hors des cavités en conservant une partie dite utile du matériau de remplissage dans les cavités, la partie utile formant un bouchon (31, 41).

5. Procédé selon la revendication précédente, dans lequel la gravure est une gravure sélective dudit matériau de remplissage vis-à-vis du matériau d'espaceurs et du matériau de l'au moins une zone active (11).

6. Procédé selon l'une quelconque des revendications précédentes, dans lequel le remplissage forme une pluralité de bouchons (31), chaque bouchon (31) remplissant une cavité (13) au sein de la zone d'isolation électrique (12) et présentant une hauteur égale à une profondeur de ladite cavité (13) de façon à combler ladite cavité.

## Patentansprüche

1. Verfahren zur Erstellung einer Komponente auf Basis einer Vielzahl von Transistoren auf einem Substrat, das eine aktive Zone (11) und eine elektrische Isolationszone (12) umfasst, wobei jeder Transistor der Vielzahl von Transistoren ein Gate (21) und Abstandshalter (22) auf beiden Seiten des Gates (21) umfasst, wobei die elektrische Isolationszone (12) mindestens einen Hohlraum (13) umfasst, der zwischen einem Abstandshalter (22a) eines ersten Transistors der Vielzahl von Transistoren und einem Abstandshalter (22b) eines zweiten Transistors der Vielzahl von Transistoren vertieft ausgebildet ist, wobei der erste Transistor und der zweite Transistor benachbart sind, wobei das Verfahren umfasst:
- eine Bildung der Gates der Transistoren,
- eine Bildung der Abstandshalter, und
- eine Bildung einer mechanisch bindenden Schicht (15) für die Transistoren,
- nach der Bildung der Abstandshalter und vor der Bildung der mechanisch bindenden Schicht, eine Füllung, konfiguriert, um den mindestens einen Hohlraum (13) innerhalb der elektrischen Isolationszone zwischen dem Abstandshalter (22a) des ersten Transistors und dem Abstandshalter (22b) des zweiten Transistors mindestens teilweise mit Füllmaterial zu füllen,
wobei das Verfahren ferner umfasst:
- mindestens einen technologischen Schritt, dem Füllen nachfolgend und eine Abnützung des Materials, dielektrisches Material genannt, der mindestens einen elektrischen Isolationszone im Bereich der exponierten Abschnitte der mindestens einen elektrischen Isolationszone einschließend,
wobei das Füllmaterial auf einem kohlenstoffhaltigen Material basiert, so konfiguriert, dass es während des mindestens einen technologischen Schrittes, der eine Abnützung des dielektrischen Materials einschließt, nicht abgenützt wird, wodurch die Abnützung des dielektrischen Materials begrenzt oder verhindert wird,
wobei das Verfahren **dadurch gekennzeichnet ist, dass** das Füllmaterial vor einer Hochtemperatur-Wärmebehandlung entfernt wird, die zwischen einem Diffusionsglühen und einem Aktivierungsglühen ausgewählt wird.

2. Verfahren nach dem vorhergehenden Anspruch, ferner eine Bildung von Source- und Drain-Zonen durch Dotierung von Abschnitten der aktiven Zone umfassend, wobei die Abschnitte auf beiden Seiten der Gates angeordnet sind, wobei das Füllen des mindestens einen Hohlraums (13) nach der Bildung der Source- und Drain-Zonen erfolgt.

3. Verfahren nach einem der vorhergehenden Ansprüche, wobei die Füllung konfiguriert ist, um den mindestens einen Hohlraum (13) vollständig mit dem Füllmaterial zu füllen.

4. Verfahren nach einem der vorhergehenden Ansprüche, wobei die Füllung ein Abscheiden des Füllmaterials zwischen dem Abstandshalter (22a) des ersten Transistors und dem Abstandshalter (22b) des zweiten Transistors innerhalb und außerhalb des mindestens einen Hohlraums (13) umfasst, gefolgt von einer Ätzung des Füllmaterials, konfiguriert, um einen Teil, Opferteil genannt, des Füllmaterials aus den Hohlräumen zu entfernen, einen Teil, Nutzteil genannt, des Füllmaterials in den Hohlräumen bewahrend, wobei der Nutzteil einen Stopfen (31, 41) bildet.

5. Verfahren nach dem vorhergehenden Anspruch, wobei die Ätzung eine selektive Ätzung des Füllmaterials gegenüber dem Material der Abstandshalter und dem Material der mindestens einen aktiven Zone (11) ist.

6. Verfahren nach einem der vorhergehenden Ansprüche, wobei die Füllung eine Vielzahl von Stopfen (31) bildet, wobei jeder Stopfen (31) einen Hohlraum (13) innerhalb der elektrischen Isolationszone (12) füllt und eine Höhe aufweist, die einer Tiefe des Hohlraums (13) entspricht, um auf diese Weise den Hohlraum auszugleichen.

## Claims

1. A method for producing a component based on a plurality of transistors on a substrate comprising an active area (11) and an electrical isolation area (12), each transistor of the plurality of transistors comprising a gate (21) and spacers (22) on either side of the gate (21), the electrical isolation area (12) comprising at least one cavity (13) formed as a hollow between a spacer (22a) of a first transistor of the plurality of transistors and a spacer (22b) of a second transistor of the plurality of transistors, said first transistor and second transistor being adjacent, the method comprising:
- forming the gates of the transistors,
- forming the spacers, and
- forming a mechanically constraining layer (15) for the transistors,
- after forming the spacers and before forming the mechanically constraining layer, a filling configured to at least partially fill with a filling material the at least one cavity (13) within the electrical isolation area, between the spacer (22a) of the first transistor and the spacer (22b) of the second transistor,
the method further comprising:
- at least one technological step subsequent to the filling and involving consumption of the material, called dielectric material, of the at least one electrical isolation area at exposed portions of the at least one electrical isolation area,
said filling material being based on a carbon material configured not to be consumed during the at least one technological step involving a consumption of the dielectric material, thus limiting or eliminating the consumption of the dielectric material,
the method being **characterised in that** said filling material is removed before a high temperature heat treatment taken from a diffusion anneal and an activation anneal.

2. The method according to the preceding claim further comprising forming source and drain areas by doping portions of the active area, said portions being located on either side of the gates, wherein the filling of at least one cavity (13) is carried out after said formation of source and drain areas.

3. The method according to any one of the preceding claims, wherein the filling is configured to completely fill the at least one cavity (13) with the filling material.

4. The method according to any one of the preceding claims, wherein the filling comprises depositing the filling material between the spacer (22a) of the first transistor and the spacer (22b) of the second transistor, in and out of the at least one cavity (13), followed by an etching of the filling material configured to remove a part called sacrificial part of the filling material out of the cavities while retaining a part called useful part of the filling material in the cavities, the useful part forming a plug (31, 41).

5. The method according to the preceding claim, wherein the etching is a selective etching of said filling material relative to the material of the spacers and the material of the at least one active area (11).

6. The method according to any one of the preceding claims, wherein the filling forms a plurality of plugs (31), each plug (31) filling a cavity (13) within the electrical isolation area (12) and having a height equal to a depth of said cavity (13) so as to close said cavity.
